Europäisches Patentamt

European Patent Office

Office européen des brevets

(19)

(11) Publication number: **0 417 948 A2**

# EUROPEAN PATENT APPLICATION

(21) Application number: 90309588.3

(51) Int. Cl.⁵: **C30B 15/00, C30B 29/06**

(22) Date of filing: **31.08.90**

(30) Priority: **31.08.89 JP 225913/89**

(43) Date of publication of application:
**20.03.91 Bulletin 91/12**

(84) Designated Contracting States:
**DE GB NL**

(71) Applicant: **NIPPON STEEL CORPORATION**
**6-3 Otemachi 2-chome Chiyoda-ku**
**Tokyo 100(JP)**

Applicant: **NSC ELECTRON CORPORATION**
**6-2, Otemachi 2-chome, Chiyoda-ku**
**Tokyo(JP)**

(72) Inventor: **Meguro, Seizou, c/o NSC Electron**
**Corporation**
**3434, Oaza-Shimada**
**Hikari-shi, Yamaguchi-ken(JP)**
Inventor: **Harada, Hirofumi, c/o NSC Electron**
**Corporation**
**3434, Oaza-Shimada**
**Hikari-shi, Yamaguchi-ken(JP)**
Inventor: **Habu, Ryuichi, c/o Nippon Steel**
**Corporation**
**6-3, Otemachi 2-chome, Chiyoda-ku**
**Tokyo(JP)**

(74) Representative: **Rees, David Christopher et al**
**Kilburn & Strode 30 John Street**
**London WC1N 2DD(GB)**

(54) Method and apparatus for pulling up silicon single crystal.

(57) A method and apparatus for drawing up a single crystal (3) of silicon upwards from a melt (2) in a crucible (1). An inverted cone-shaped tube (4) is interposed between the silicon crystal and the crucible. The lower end of the tube (4) is located in close proximity to the outer peripheral surface of the silicon crystal (3) and the liquid surface of the melt (2). The surface of the tube is formed of a non-metallic substance, the lower end part being of an opaque material (5), the remainder being of a transparent material.

EP 0 417 948 A2

## METHOD AND APPARATUS FOR PULLING UP SILICON SINGLE CRYSTAL

This invention relates to a method and apparatus for pulling up a single crystal of silicon. More particularly, this invention relates, in the production of a single crystal of silicon by the Czochralski method, to a method and an apparatus for preventing the single crystal of silicon from being defiled with a metallic impurity and, at the same time, precluding the occurrence of oxidation-induced stacking fault (OSF) in the single crystal of silicon.

As a means of producing a single crystal, the CZ method which comprises growing and, at the same time, pulling up a crystal from a melt in a crucible is widely practiced. The growth of a single crystal of silicon by this CZ method is started by charging a quartz crucible disposed in a chamber with prescribed amounts of raw materials such as polycrystalline silicon and a dopant and the like which are optionally added and heating the crucible with a heater encircling the crucible thereby melting the raw materials and forming a melt. The growth is then accomplished by dipping in the melt of raw materials formed in the crucible a seed crystal attached to the leading end of a pulling wire and pulling up the wire while keeping the quarts crucible and the seed crystal rotated thereby growing a single crystal of silicon at the lower end of the seed crystal.

Incidentally, during the pull of the single crystal of this kind, silicon monoxide (SiO), for example, is vaporizing from the melt of high temperature formed inside the crucible. When the vapor condenses on the wall surface of the chamber and falls and reaches the boundary of growth of the single crystal, the crystal has a strong possibility of undergoing dislocation.

During the operation of pulling up the single crystal in the manner described above, therefore, the practice of causing an inert gas such as argon gas to flow down the chamber from above and expelling the vapor out of the system as entrained by the downflow of the inert gas thereby curbing the occurrence of the dislocation mentioned above has been in vogue. When the downflow of the inert gas is established inside the chamber as described above, however, the effect thereof is not fully satisfactory because the inert gas inevitably finds a place to stagnate inside the chamber.

Japanese Patent Publication SHO 57(1982)-40, 119 has disclosed a method which, in the operation of the CZ method, comprises providing a single crystal of silicon in the process of being pulled up with a cover in the shape of an inverse cone having an axis coinciding with the axis of the single crystal of silicon and having a lower end thereof closely approximating the outer peripheral surface of the single crystal of silicon and the liquid surface of the melt thereby intercepting the heat of radiation from the crucible wall and allowing an addition to the pulling speed of the crystal and, at the same time, preventing the vapor of the melt from advancing to the upper part of the single crystal of silicon and precluding the possibility of the vapor condensing and falling onto the single crystal of silicon and compelling the single crystal to attain growth in a dislocated state.

The cover of the shape of an inverted cone, for the purpose of reflecting the heat of radiation, is made of such a metal as tungsten, niobium, tantalum, steel, nickel, or germanium. When the single crystal of silicon is pulled up in the CZ apparatus provided with the cover, the problem arises that the product of the reaction between the metal of which the cover is made and the SiO gas vaporizing the melt falls and dissolves in the melt of silicon and causes metallic contamination of the single crystal of silicon.

For the solution of this problem, it has been proposed in Japanese Patent Unexamined Publication SHO 62(1987)-138,386 to form the outer surface side of the aforementioned inverted cone-shaped cover with a ceramic material stable at elevated temperatures so as to avoid the otherwise inevitable metallic defilement and form the intermediate layer of the cover with a carbonaceous heat insulator and the inner surface side of the cover with carbon of high thermal emission so as to heighten the pulling speed.

It has been found by the present inventors that the materials in common use which are composed of a single crystal of silicon doped to n-type (P dopant, materials free from additive, and p-type high-resistant materials) suffer from conspicuous occurrence of OSF when the cooling speed of various sites of a crystal in the process of being pulled up is increased past 5°C/min in a temperature zone falling below 800°C. When the single crystal of silicon is pulled up in the apparatus provided with the inverted cone-shaped cover of the foregoing description, therefore, the problem ensues that the single crystal is susceptible of the OSF because the heat of radiation is intercepted and the cooling speed is heightened.

An object of this invention, therefore, is to provide an improved method and an apparatus for pulling up a single crystal of silicon. Another object of this invention is to provide, in the production of a single crystal of silicon by the Czochralski method, a method and an apparatus for pulling up a single crystal of silicon, which prevent the single crystal of silicon from being defiled with impurities and, at the same time, precludes the occurrence of oxidation-induced stacking fault (OSF) in the single crystal of silicon.

To accomplish the objects described above, this invention provides a method for pulling up a single crystal of silicon from a melt in a crucible, which method is characterized by. interposing between the single crystal of silicon in the process of being pulled up and the crucible a tube of the shape of an inverted cone having the lower end thereof disposed in close approximation to the outer peripheral surface of the single crystal of silicon and the liquid surface of the melt and having at least the surface thereof formed of a nonmetallic substance, the lower end part thereof formed of an opaque material, and the other parts thereof formed of a transparent material.

These objects are further accomplished by an apparatus for pulling up a single crystal of silicon from a melt in a crucible, which apparatus is characterized by the fact that a tube of the shape of an inverted cone having at least the surface thereof formed of a nonmetallic substance, the lower end part thereof formed of an opaque material, and the other parts thereof formed of a transparent material is so disposed as to have the axis thereof coinciding with the pulling direction of the single crystal of silicon and the lower end thereof falling in close approximation to the outer peripheral surface of the single crystal of silicon and the liquid surface of the melt.

The present invention, in the production of a single crystal of silicon in accordance with the Czochralski (CZ) method, improves the pulling speed of the single crystal, prevents the occurrence of crystal fault and improves the freeing ratio of the single crystal during the course of pulling, prevents the single crystal from metallic contamination and, at the same time, precludes the occurrence of oxidation-induced stacking fault in the single crystal owing to the provision in the upper part of the crucible containing the melt a tube of the shape of an inverted cone having at least the surface thereof formed of a nom-metallic material, the lower end part thereof formed of an opaque material, and the other parts thereof formed of a transparent material.

Figure 1 is a cross-section through an apparatus for pulling up a single crystal of silicon in accordance with the invention, with components in their operative conditions; and

Figure 2 is a similar view showing an alternative embodiment.

The invention may be carried into practice in various ways and some embodiments will now be described by way of example with reference to the accompanying drawings, in which:-

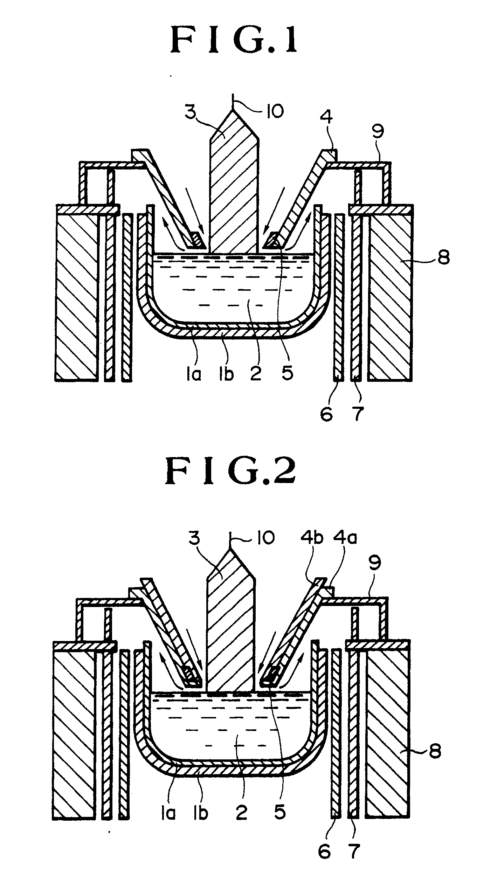

In the apparatus for pulling up a single crystal of silicon in the embodiment illustrated in Figure 1, a single crystal of silicon 3 is pulled up from a melt 2 formed in a crucible 1. Between the single crystal 3 of silicon in the process of being pulled up and the crucible 1, a tube 4 made of transparent quartz in the shape of an inverted cone is interposed as disposed around the single crystal 3 of silicon as the axis thereof. An opaque ring 5 having the surface thereof formed of a nonmetallic material is attached to the inner peripheral surface of the lower end part of the inverted cone-shaped tube 4. This opaque ring 5 is so disposed that the lower end thereof falls in close approximation to the single crystal 3 of silicon and the melt 2. In Fig. 1, the melt 2 is heated with a cylindrical heater 6 and is covered with an inner shield 7 and an outer shield 8 which are both cylindrical in shape. The inverted cone-shaped tube is is supported on a supporting base 9 disposed on the inner shield 7 and the outer shield 8. In the diagram, the reference numeral 10 stands for a seed crystal used for the growth of the single crystal.

As in the present embodiment, the transparent part of the inverted cone-shaped tube 4 according with the present invention is desired to be formed of transparent quartz. As a material for the opaque part, graphite or a ceramic substance may be used. The transparent part and the opaque part of the inverted cone-shaped tube 4 are only required to have their surfaces formed of a nonmetallic material as mentioned above. The opaque part may be formed of a metallic material if the metallic material was coated with quartz or a ceramic substance. The term "transparent" as used in this invention refers to a substance pervious to the heat of radiation from the heater, the crucible, or the melt and the term "opaque" to a substance impervious to the heat of radiation.

The apparatus for pulling up a single crystal of silicon in the other embodiment illustrated in Fig. 2 is identical in construction with the embodiment illustrated in Fig. 1, excepting the inverted cone-shaped tube 4 has an opaque ring 5 of a nonmetallic material nipped between the lower end parts of an outer peripheral member 4a made of transparent quartz and an inner peripheral member 4b made of transparent quartz. The fact that the opaque member of nonmetallic material attached to the lower end part of the inverted cone-shaped tube as in the present embodiment is advantageous in respect that it will contribute to preventing the melt from contamination.

The operation of pulling up the single crystal of silicon contemplated by the present invention is carried out by the use of the apparatus constructed as described above in accordance with the CZ method. For the prevention of the occurrence of OSF, the cooling speed of various sites of the single crystal 3 of silicon is desired to be not more than $4^\circ$ C/min in a temperature zone not exceeding $800^\circ$ C.

In accordance with the method and the apparatus of this invention for pulling up the single crystal of silicon, the possibility of the vapor from the melt 2 causing dislocation in the single crystal 3 of silicon in the process of being pulled up can be precluded because the inverted cone-shaped tube 4 is interposed between the single crystal 3 of silicon and th crucible 1 as disposed in close approximation to the single crystal 3 of silicon and the melt 2 as illustrated in Figs. 1 and 2. Since the surface of the inverted cone-shaped tube 4 is made of a nonmetallic material, it gives rise to no reaction product on contact with the SiO vaporizing from the melt 2 and, therefore contributes to preventing the melt 2 from metallic contamination. Further, since the lower end part of the inverted cone-shaped tube 4 is opaque and the other parts thereof are transparent, the single crystal 3 of silicon immediately after being pulled up the melt 2 is protected by the opaque part against the heat of radiation emanating from the melt 2 and the crucible 1 and, therefore, can be pulled up at a higher speed. Since the single crystal 3 of silicon further grown thereafter is properly protected by the transparent part, the cooling speed of the various sites of the single crystal 3 of silicon in the process of being pulled up can be adjusted to a proper level not exceeding $5^\circ$ C/min and the occurrence of OSF can be precluded. In the inverted cone-shaped tube 4 contemplated by the present invention, though the length of the lower end part which is rendered opaque depends on the conditions for growth such as the pulling speed of the single crystal 3 of silicon, the temperature of the melt, and the diameter of the single crystal being pulled up or on the size of the inverted cone-shaped tube 4, the angle of inclination of the wall surface, and so on, it is generally desired to be such that the opaque lower end part rises to a height in the range of up to 8 cm, preferably up to 5 cm, above the liquid surface of the melt 2. The length of the opaque lower end part, however, has no particular restriction except for the sole requirement that it should contribute to improving the pulling speed as described above and avoid obstructing the retentio of the cooling speed at a level below $5^\circ$ C/min.

EXAMPLES

Now, the present invention will be described specifically below with reference to working examples.

Example 1

In an apparatus constructed as illustrated in Fig. 1, 45 kg of polycrystalline silicon was placed and melted in a quartz crucible 1a having an inside diameter of 16 inches and reinforced externally with a graphite crucible 1b. From the melt, a single crystal 3 of silicon 130 mm in diameter was pulled up. An opaque ring 5 made of graphite was attached to the inner surface side of the lower end part of an inverted cone-shaped tube 4 made of transparent quartz. Argon gas was passed through the gap between the single crystal 3 of silicon and the lower end of the inverted cone-shaped tube 4 at a flow volume in the range of 15 to 100 liters/min in the direction of the arrow so as to maintain in the interior of the apparatus an argon gas atmosphere having an inner pressure in the range of 5 to 30 millibars.

As the result, a single crystal of silicon was obtained at a pulling speed of 1.5 mm/min and the occurrence of dislocation of the crystal in the process of pulling up was prevented and the metallic contamination of the crystal was precluded. The OSF density in the produced single crystal was conspicuously small as compared with that in the product of the comparative method as shown in Table 1. The experiment of the convetional method was carried out by following the procedure of this example, excepting an inverted cone-shaped tube 4 was formed wholly of an opaque heat insulator. The OSF density of a given single crystal of silicon was determined by heating the sample in a moist oxygen gas at $1,000^\circ$ C for 60 minutes and subjecting the treated sample to visual observation under a microscope.

Example 2

In an apparatus constructed as illustrated in Fig. 2, 45 kg of polycrystalline silicon was placed and melted in a quartz crucible 1a having an inside diameter of 16 inches and reinforced externally with a graphite crucible 1b. From the melt, a single crystal 3 of silicon 130 mm in diameter was pulled up. An inverted cone-shaped tube 4 of transparent quartz was composed of an outer peripheral member 4a and an inner peripheral member 4b and had an opaque ring 5 of graphite nipped between the lower end parts of the two members mentioned above. Argon gas was passed through the gap between the single crystal 3 of silicon and the lower ends of the inverted cone-shaped tube 4 at a flow volume in the range of 15 to 100 liters/min in the direction of the arrow so as to maintain in the apparatus an argon gas atmosphere having an inner pressure in the range of 5 to 30 millibars

As the result, a single crystal of silicon was obtained at a pulling speed of 1.5 mm/min and the occurrence of dislocation of the crystal in the process of being pulled up was prevented and the metallic contamination of the crystal was precluded. As shown in Table 1, the OSF density of the produced single crystal was conspicuously small as compared with that in the product of the comparative method.

Table 1

| Type of experiment | OSF density (pieces/cm$^2$) |
|---|---|
| Example 1 | $3 \times 10^1 - 1 \times 10^3$ |
| Example 2 | $3 \times 10^1 - 1 \times 10^3$ |
| Conventional method | $5 \times 10^3 - 3 \times 10^4$ |

## Claims

1. A method for drawing a single crystal (3) of silicon upwards from a melt (2) in a crucible (1), which comprises interposing between the crucible (1) and the crystal (3) of silicon while it is being drawn upwards, a tube (4) in the shape of an inverted cone, whose lower end is disposed in close proximity to the outer peripheral surface of the silicon crystal (3) and the liquid surface of the melt (2), the tube (4) having at least its surface formed of a non-metallic substance, characterised in that the lower end part of the tube is formed of an opaque material (5), while its other parts are formed of a transparent material.

2. A method as claimed in Claim 1, characterised in that the cooling rate of the various parts of the single crystal (3) of silicon during the process of its being drawn upwards is not higher than 4C°/min at a temperature zone not exceeding 800°C.

3. An apparatus for drawing a single crystal of silicon upwards from a melt (2) in a crucible (1), including a tube (4) in the shape of an inverted cone having at least its surface formed of a non-metallic substance, the tube being so disposed as to have its axis coincident with the pulling direction of the silicon crystal (3) and to have its lower end in close proximity to the outer peripheral surface of the silicon crystal (3) and the liquid surface of the melt (2), characterised in that the lower end part of the tube (4) formed of an opaque material (5), while its other parts are formed of a transparent material.

4. Apparatus as claimed in Claim 3 characterised in that the tube (4) is made of transparent quartz in the shape of an inverted cone having attached at its lower end an opaque member (5) whose surface is made of a non-metallic material.

5. Apparatus as claimed in Claim 3, characterised in that the tube comprises an opaque ring (5) made of a non-metallic material, an outer peripheral member (4a) made of transparent quartz, and an inner peripheral member (4b) made of transparent quartz, the opaque ring (5) being nipped between the lower end parts of the outer peripheral member (4a) and the inner peripheral member (4b) so as to be enveloped.

6. A cover in the shape of an inverted cone (4) for location in the upper part of a crucible (1) containing a melt (2) and housed in an apparatus for drawing upwards a single crystal (3) of silicon, at least the surface of the cover being formed of a non-metallic material, characterised in that the lower end part of the cover (4) formed of an opaque material (5), while its other parts are formed of a transparent material.

7. A cover as claimed in Claim 6, characterised in that it comprises a tube made of transparent quartz in the shape of an inverted cone (4) having an opaque member (5) made of a non-metallic material attached at its lower end.

8. A cover as claimed in Claim 6, characterised in that it comprises a tube in the shape of an inverted cone (4) comprising an opaque ring (5) made of a non-metallic material, an outer peripheral member (4a) made of transparent quartz, and an inner peripheral member (4b) made of transparant quartz, the opaque ring (5) being nipped between the lower end parts of the outer peripheral member (4a) and the inner peripheral member (4b) so as to be enveloped.

# FIG.1

# FIG.2